(19) Europäisches Patentamt
European Patent Office
Office européen des brevets

(11) **EP 3 066 421 B1**

(12) # EUROPÄISCHE PATENTSCHRIFT

(45) Veröffentlichungstag und Bekanntmachung des Hinweises auf die Patenterteilung:
**03.01.2018 Patentblatt 2018/01**

(51) Int Cl.:
**G01D 5/14** *(2006.01)*          **G01D 5/16** *(2006.01)*
**G01R 33/09** *(2006.01)*

(21) Anmeldenummer: **14815217.6**

(22) Anmeldetag: **03.11.2014**

(86) Internationale Anmeldenummer:
**PCT/DE2014/000560**

(87) Internationale Veröffentlichungsnummer:
**WO 2015/062573 (07.05.2015 Gazette 2015/18)**

(54) **MAGNETISCHER SENSOR ZUR ABSOLUTEN ZÄHLUNG VON UMDREHUNGEN ODER LINEAREN WEGSTRECKEN**

MAGNETIC SENSOR FOR ABSOLUTE COUNT OF REVOLUTIONS OR LINEAR DISTANCES

CAPTEUR MAGNÉTIQUE POUR RECENSEMENT ABSOLU DE ROTATIONS OU DE DISTANCES LINEAIRES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.11.2013 DE 102013018680**

(43) Veröffentlichungstag der Anmeldung:
**14.09.2016 Patentblatt 2016/37**

(73) Patentinhaber:
• **Leibniz-Institut für Photonische Technologien e.V.**
**07745 Jena (DE)**
• **Horst Siedle GmbH & Co. KG.**
**78120 Furtwangen (DE)**

(72) Erfinder:
• **MATTHEIS, Roland**
**07743 Jena (DE)**

• **DIEGEL, Marco**
**07743 Jena (DE)**

(74) Vertreter: **Pfeiffer, Rolf-Gerd**
**Patentanwaltsbüro**
**Pfeiffer & Kollegen**
**Engelplatz 11**
**07743 Jena (DE)**

(56) Entgegenhaltungen:
**WO-A2-2009/004293          DE-A1-102008 063 226**
**DE-A1-102010 022 611**

• **MATTHEIS R ET AL: "Concepts and steps for the realization of a new domain wall based giant magnetoresistance nanowire device: From the available 2multiturn counter to a 2turn counter", JOURNAL OF APPLIED PHYSICS, AMERICAN INSTITUTE OF PHYSICS, US, Bd. 111, Nr. 11, 1. Juni 2012 (2012-06-01) , Seiten 113920-113920, XP012157712, ISSN: 0021-8979, DOI: 10.1063/1.4728991 [gefunden am 2012-06-15]**

EP 3 066 421 B1

**Beschreibung**

Die Erfindung betrifft einen magnetischen Sensor zur absoluten Zählung von Umdrehungen oder linearen Wegstrecken, der in vielfältigen Gebieten der Technik, insbesondere im Automobilbau und in der Industrieautomatisierung vorteilhaft Anwendung finden kann. Insbesondere soll der neuartige Aufbau des vorgeschlagenen Sensors die kontaktfreie und stromlose Zählung von hohen Umdrehungszahlen in der Größenordnung von 4000 oder größeren Wegstrecken in der Größenordnung von 20000 mm ermöglichen, was für eine Vielzahl von technischen Anwendungen von Interesse ist. Aber auch zur Ermittlung von kleinen Umdrehungszahlen ist der vorgeschlagene Sensor bei gleichzeitig einfachstem Aufbau ausgesprochen vorteilhaft z.B. im Automobilbau zur exakten Bestimmung von Takten von Verbrennungsmotoren einsetzbar und kann bspw. gemeinsam mit einem Winkelsensor die Funktion von Nockenwellen übernehmen und diese teuren Bauteile somit ersetzen. Sensoren zur Bestimmung einer Winkellage nach unterschiedlichen physikalischen Prinzipien sind weit verbreitet. Ihnen gemein ist, dass das Sensorsignal nach 360° periodisch ist, d.h. dass der Sensor nicht zwischen 10° und 370° unterscheiden kann. Deshalb werden derartige Sensoren für Aufgabenstellungen, bei denen über die 360° hinaus der Winkel bestimmt werden muss, wie es z.B. beim Lenkrad im Automobil der Fall ist, kombiniert mit einem weiteren Sensor, der in der Lage sein muss, die Anzahl der Umdrehungen zu detektieren, gefordert. In Kombination mit einem Umdrehungszähler kann dann zwischen 10° und 370° unterschieden werden. Zur Bestimmung der Anzahl der Umdrehungen sind Lösungen bekannt, bei denen mechanisch über den Gang einer Spirale mit N Spiralenarmen auf die Anzahl der Umdrehungen (bspw. zwischen 1...5) geschlossen werden kann. Andere Lösungen nutzen mechanische Getriebe in Verbindung mit zwei oder mehreren Winkelsensoren. Aus der Kenntnis des Aufbaus des Getriebes und der Winkellage der Magneten, die mit unterschiedlichen Rädern des Getriebes verbunden sind, kann der Winkel auch z.B. von 0 bis 5 · 360° bestimmt werden. Allen diesen Lösungen ist es gemein, dass sie zur Realisierung eine Mechanik benötigen, sie also nicht berührungs- und damit nicht verschleißfrei sind. Für viele Anwendungen, insbesondere im Automobil, ist jedoch eine berührungsfreie Lösung erforderlich. Dies könnte so realisiert werden, dass man zu jedem Zeitpunkt (permanent) die Winkellage bestimmt und auf diese Art ein Übergang von 359° auf 360° vom Winkel 0° unterschieden werden kann. Dies setzt voraus, dass der Sensor und ein zugehöriges Speicherelement permanent mit elektrischer Energie versorgt werden. Dies widerspricht der Forderung im Automobilbau, dass die Bestimmung des Absolutwinkels im Bereich von z.B. 0° bis bspw. 5 · 360° auch dann erfolgreich sein muss, wenn z.B. die Bordelektronik von der Batterie abgeklemmt ist.

Eine berührungsfreie Zählung der Anzahl von Umdrehungen, die diese Forderungen im Prinzip erfüllt, wurde von der Fa. Posital (Firmenmitteilung "Kraftwerk im Encoder..." www.postal.de) entwickelt. Dort wird ein Hallsensor zur Bestimmung des Winkels (0 - 360°) genutzt. Die Messung der Anzahl der Umdrehungen geschieht dort mit Hilfe eines so genannten Wieganddrahtes. Dieser Draht besitzt spezielle magnetische Eigenschaften, die dafür sorgen, dass nach einer jeden Umdrehung durch die dann ablaufende plötzliche Bewegung einer magnetischen Domänenwand durch einen einige Millimeter langen Draht ein kurzer, aber hinreichend intensiver Spannungsimpuls entsteht, der in ein FeRAM (Ferroelektrisches Random Access Memory) eingeschrieben werden kann, auch ohne dass das FeRAM mit der Batterie verbunden ist. Diese Lösung erfüllt damit die Forderung nach der Bestimmung der Anzahl der Umdrehungen verschleiß- und berührungsfrei und zählt auch ohne Anliegen der Stromversorgung Umdrehungen bis zur maximalen Speicherkapazität des eingesetzten Fe-RAMS. Jedoch wird eine solche Lösung von der Automobilindustrie abgelehnt, da auf Grund der makroskopischen Größe des Wieganddrahtes eine kostengünstige Herstellung und Konfektionierung nicht möglich ist und durch den hochohmigen Eingang der FeRAM's Probleme mit der elektromagnetischen Verträglichkeit bestehen.

Ein weiteres Sensorelement zur Zählung von Umdrehungen, das die oben genannten Anforderungen erfüllt, ist aus der EP 1 740 909 B1 (WO 2005/106395) bekannt. Dieses Sensorelement hat die Form einer lang gestreckten Spirale mit N Windungen und besteht aus einem Schichtstapel, der den "Giant magnetoresistance effect" (GMR) aufweist. Das GMR-Schichtsystem dieses Sensorelementes besteht im Wesentlichen aus einer hartmagnetischen Schicht, welche die Referenzrichtung definiert und einer weichmagnetischen Schicht, getrennt durch eine unmagnetische Zwischenschicht. Das äußere zu detektierende, sich drehende Magnetfeld ist stark genug, um durch Bewegung von Domänenwänden die Magnetisierungsrichtung der weichmagnetischen Schicht zu ändern, aber zu schwach für eine Änderung der Magnetisierungsrichtung der hartmagnetischen Schicht, die parallel zu den geraden Strecken der lang gestreckten Spirale verläuft. Das Sensorelement reagiert somit auf ein sich drehendes Magnetfeld mit einer Widerstandsänderung, wobei innerhalb des zählbaren Bereiches von 0 bis N Umdrehungen ganze und halbe Umdrehungen in Form von 2N+1 Widerstandswerten registriert werden. Jeder Widerstandswert ist dabei eineindeutig einem halbzahligen oder ganzzahligen Umdrehungswert zugeordnet. Die magnetische Struktur bleibt dabei unverändert, wenn das Magnetfeld keine Rotation ausführt. Bei Rotation ändern sich die Magnetisierungsrichtungen, unabhängig davon, ob der Widerstandswert ausgelesen wird oder nicht. Dies bedeutet, dass das System auch in einem strom- oder leistungslosen Zustand alle Änderungen des sich drehenden Magnetfeldes registriert und nur zur Auslesung, also Bestimmung des Widerstandes, eine Stromversorgung benötigt.

Nachteil einer solchen Anordnung ist, dass aufgrund der verwendeten Speichergeometrie (jede Umdrehung benötigt eine komplette Spiralwindung), bei Zählung von einer größeren Anzahl von Umdrehungen, die Spirale geometrisch sehr groß werden muss. Damit steigt einerseits die Wahrscheinlichkeit dafür, dass bei der Herstellung der Spirale auftretende Defekte zu einem Ausfall und damit zu einer Verringerung der Ausbeute führen. Andererseits steigen damit die Chipfläche und somit die Kosten für einen derartigen Sensor. Des Weiteren führt das in EP 1 740 909 B1 angegebene Konzept bei einer großen Anzahl von Spiralwindungen automatisch zu Problemen bei der Bestimmung der Anzahl der Umdrehungen. Der verwertbare Spannungshub, der sich von einer Umdrehung zur nächsten ergibt, skaliert mit 1/Anzahl der Spiralwindungen. Für N > bis >> 10 wird er für eine sichere Auswertung deutlich zu klein. Eine Alternative, wie sie in genanntem Patent angegeben wurde, erlaubt zwar bei größeren Umdrehungszahlen den vollen Magnetowiderstandshub, hat aber ebenfalls den Nachteil einer langen Spirale und erkauft den Vorteil des großen Hubes dadurch, dass statt zweier elektrischer Kontakte alle einen nicht geschlossenen Kreis bildenden Spiralenteile mit jeweils vier elektrischen Kontakten versehen und elektrisch ausgelesen und verarbeitet werden müssen. Das ergibt schon bei N=100 vierhundert Kontakte und damit einen großen schaltungstechnischen Aufwand. Hinzu kommt bei vorstehend beschriebener Lösung das Problem, dass nach Erreichen der maximal in der Spiralleitbahn führbaren Domänen die Leitbahn vollständig mit Domänen besetzt ist und bei jeder weiteren Halbumdrehung eine Domäne die Leitbahn verlässt, wobei zugleich eine neue wieder eingespeist wird. Damit ist eine Eindeutigkeit der Umdrehungszählung bei n Windungen und damit 2n Domänen beendet. Eine in der Richtung umgekehrte Umdrehung des äußeren rotierenden Magnetfeldes leert die Spirale letztendlich vollständig von Domänen, so dass auch in der Rückrichtung nach Überschreiten der maximal detektierbaren Umdrehungen keine eindeutige Zählung mehr möglich ist.

Der Behebung vorstehend beschriebener Probleme nahm sich bereits ein Vorschlag gemäß WO 2009/027046 A1 an, bei dem ein magnetischer Umdrehungszähler zur eindeutigen Bestimmung einer vorgebbaren Anzahl zu bestimmender Umdrehungen eines rotierenden Elements vorgeschlagen wurde, bei dem in Abhängigkeit von der Anzahl zu messender Umdrehungen des zu detektierenden Elements, welches mit einem Magnetsystem versehen ist, dessen Magnetfeld alle vorgesehenen Sensorelemente zu erfassen gestattet, mehrere Sensorelemente vorgesehen sind, wobei die Sensorelemente mit magnetischen Domänen einer vorbestimmbaren und fest gehaltenen Anzahl besetzt wurden. Die Domänen werden nach diesem Vorschlag in -in sich jeweils geschlossenen- Schleifen geführt, die wenigstens eine ferromagnetische, respektive weichmagnetische Schicht beinhalten, wobei den Schleifen ins Schleifeninnere gerichtete, spitz zulaufende Ausstülpungen zugeordnet wurden und die Anzahl der pro Schleife vorgesehenen Ausstülpungen von Schleife zu Schleife voneinander abweichend definiert festgelegt ist. Vermittels dort vorgesehener elektrischer Kontaktanordnungen, die Veränderungen des elektrischen Widerstands vorgebbarer Schleifenabschnitte nach erfolgtem Ortswechsel magnetischer Domänen, infolge der Einwirkung des äußeren rotierenden Magnetfeldes des Magnetsystems in den vorgegebenen Schleifenabschnitten zu erfassen gestatten, können diese Widerstandswerte einer Auswerteeinheit zwecks Zuordnung der Anzahl der Umdrehungen des rotierenden Elements zugeführt werden. Die in diesem Vorschlag vorgesehenen, jeweils in sich geschlossenen Schleifen können ineinander geschachtelt oder nebeneinander auf einem Substrat angeordnet sein. Mit dieser Lösung wurden die eingangs geschilderten Probleme des erforderlichen Spannungshubs und der Eineindeutigkeit der Zählung innerhalb der vorgebbaren Grenzen bei gleichzeitig reduzierter Gesamtleiterbahnlänge gelöst. Die im Rahmen dieses Vorschlags erforderlichen spitz zulaufenden Ausstülpungen stellen jedoch erhebliche Anforderungen an die Herstellungstechnologie. Die Spitzen sind nämlich sehr präzise und in einem Winkel kleiner 15° auszuführen. Will man dazu nicht auf sehr aufwändige und damit wiederum teure Technologien, wie FIB (focused ion beam) zurückgreifen, kommt man zumindest bei größeren Spitzenzahlen mit lithografischen Standarttechnologien sehr schnell an Grenzen bezüglich der erzielbaren Gutausbeute. Somit ist dieser Vorschlag für große preiswerte Sensorchargen mit wenig Ausschuss nur bedingt geeignet.

Darüber hinaus existiert bei vorstehender Lösung ein weiteres Problem, das in einer nicht durchgängig gleichen Domänenleitbahnbreite besteht. Dazu muss zunächst, was für alle Sensoren dieser Art gilt, auf folgenden Sachverhalt hingewiesen werden: Es existiert ein nach unten und oben beschränkter Magnetfeldbereich für das auf den Sensor einwirkende Magnetfeld, in dem eine sichere Funktionalität des Sensors bzw. -systems erreicht wird. Nur oberhalb eines Minimalmagnetfelds (im Folgenden $H_{min}$) wird eine Domäne zu 100% durch die Struktur hindurch bewegt und ein Zusammentreffen zweier Domänen und deren damit einhergehende Vernichtung und damit ungewollte Verringerung der Anzahl der Domänen sicher verhindert. Zugleich darf das Magnetfeld aber auch nicht so groß sein, dass ungewollt magnetische Domänen entstehen. Das heißt, es existiert ein Magnetfeld $H_{max}$, das nicht überschritten werden darf. Der Feldbereich des Sensors muss also immer oberhalb $H_{min}$ und unterhalb $H_{max}$ liegen. Für jede vorgesehene Anwendung des Sensors ist es vorteilhaft, wenn sowohl $H_{min}$ sehr klein als auch $H_{max}$ sehr groß und damit das sogenannte magnetische Fenster $\Delta H = H_{min} - H_{max}$ möglichst groß ist. Die Größe $H_{max}$ ist primär von dem Querschnitt des Teiles des verwendeten Schichtstapels abhängig, in dem sich die magnetischen Domänen bewegen. Es ist proportional zu dessen Dicke und indirekt proportional zu dessen Breite. Das Minimalfeld hängt von der Rauigkeit der Schicht ab. Bei konstanter absoluter Rauigkeit sinkt das $H_{min}$ mit wachsender Breite.

Bei dem Vorschlag nach WO 2009/027046 A1 erkennt man nun, dass an der Stelle des Zusammenlaufens am unteren Ende einer Spitze eine Verbreiterung auf mindestens das Doppelte der Domänenleitbahnbreite unvermeidlich ist, was zu einer merklichen Absenkung des oberen Feldes $H_{max}$ führt. Nimmt man dazu noch einen typischen minimal herstellbaren Krümmungsradius an diesem Ende der Spitze von 200 nm an (was ein typisch erreichbarer Wert für einen Standard-DUV-Waferstepper ist) erhöht sich diese Breite auf ~ 600 nm. Diese Verbreiterung führt zu einer massiven Reduktion des oberen, maximal zulässigen Feldes des magnetischen Fensters, in dem der Sensor arbeitet. Dieser Wert ist in erster Näherung indirekt proportional zur Streifenbreite (hier = 200 nm), wird also auf einen Wert von ~ 33 % des Wertes reduziert, der durch die Streifenbreite von 200 nm theoretisch eigentlich möglich wäre.

Letzteres Problem der Auswirkung von unterschiedlichen Leitbahnbreiten wurde in DE 10 2010 022 611 A1 dadurch gelöst, dass eine mit einer vorbestimmbaren Anzahl magnetischer Domänen besetzte weichmagnetische und mit GMR- oder TMR-Schichtpaketen versehene Schleifenstruktur zum Einsatz gelangt, wobei die Schleifenstruktur gebildet ist aus wenigstens zwei separaten Schleifen, die jeweils spiralförmig ausgebildet sind, wobei das jeweils erste innere Schleifenende mit dem jeweils zweiten äußeren Schleifenende der gleichen Schleife alle übrigen Schleifenabschnitte der jeweiligen Schleife in einem vorgebbaren Abstand durch je eine weichmagnetische und damit die jeweilige Schleife magnetisch schließende Brücke überbrückend verbunden ist, wobei in jede der in sich geschlossenen Schleifenstrukturen mindestens eine Domäne eingeschrieben ist. Diese Lösung, welche vorliegender Erfindung am nächsten kommt, verfügt über ein größeres magnetisches Fenster als die bis dahin bekannten vergleichbaren Lösungen, da zumindest die Herstellung durchgängig gleicher Leitbahnbreiten damit möglich ist. Jedoch erfordert die Ausbildung der dort vorgesehenen Brücken und damit die Gewährleistung gleicher Dicken der Leitbahnen in den stufenartigen Übergangsbereichen, so erhebliche technologische Anforderungen, dass eine Massenproduktion derartiger Umdrehungszähler mit einer zu hohen Ausschussrate verbunden und damit unökonomisch ist.

Ergänzend zum vorstehend beschriebenen Stand der Technik soll nur auf die Schrift DE 10 2008 063 226 A1 verwiesen werden, in der beschrieben ist, wo und wie eine sinnfällige Anbringung auslesender Kontakte am Beispiel einer rhombisch ausgeführten Spiralstruktur domänenführender Leitbahnen erfolgen sollte. Derartige Überlegungen finden auch bei hier neu vorgeschlagener Erfindung Anwendung, so dass hier nur bedingt darauf weiter eingegangen werden müsste. Ebenso gibt DE 10 2010 022 611 A1 Hinweise zu einer vorteilhaften Kontaktanbindung zur Auslesung des Sensors als auch zum definierten Einschreiben von Domänen in die Leitbahnstrukturen, die bei vorliegender Erfindung ebenfalls analog Anwendung finden können.

Aufgabe der vorliegenden Erfindung ist es, einen magnetischen Sensor zur absoluten Zählung von Umdrehungen, respektive Teilumdrehungen, oder linearen Wegstrecken anzugeben, der technologisch mit kommerziell verfügbaren Technologien einfach herstellbar ist, der über ein breiteres magnetisches Fenster als vergleichbare Sensoren nach dem bekannten Stand der Technik verfügt und der bei Beibehaltung der grundsätzlichen Topologie auf einfache Weise zur Zählung beliebig vorgebbarer und insbesondere hoher Umdrehungszahlen N (bspw. N > 4000), respektive größerer linearer Wegstrecken von z.B. 4.000 mm bis 20.000 mm, in Abhängigkeit von der gewünschten Auflösung (bspw. 50 $\mu$m - 250 $\mu$m) einsetzbar ist.

Im Rahmen der Erfindung kommen dabei weiterhin an sich bekannte Schichtaufbauten, wie z.B. in EP 1 740 909 B1 oder WO 2009/027046 A1 beschrieben, zum Einsatz, die die Bestimmung einer Domänenkonfiguration unter Ausnutzung des bekannten Effekts, dass der elektrische Widerstand in einem GMR- oder TMR-Stack von der relativen Richtung der Magnetisierung der Schicht abhängt, in der sich die Domänen, im Vergleich zu einer durch eine hartmagnetische Schicht definierten Referenzrichtung, bewegen, ermöglichen.

Im Rahmen vorliegender Erfindung wird eine neuartige Schleifentopologie vorgeschlagen, die die Aufgabe der Erfindung löst. Die wesentlichen Vorteile dieser vorgeschlagenen Topologie bestehen in einem erheblich vergrößerten magnetischen Fenster, in dem der magnetische Sensor arbeiten kann, als auch in der deutlichen Verringerung der Anforderungen an dessen Herstellung.

Das Wesen der Erfindung besteht dabei darin, dass wenigstens zwei separate, Domänen führende Schleifen mit überwiegend geraden und zueinander rhombusartig angeordnet verlaufenden Teilabschnitten vorgesehen sind und die zumindest zwei Schleifenstrukturen über einen gemeinsamen Kreuzungspunkt miteinander verbunden sind, wobei jeweils unmittelbar vor dem Kreuzungsbereich, in und nach dem die Domänen von einer in die benachbarte Schleifenstruktur wechseln können, diese Abschnitte der Schleifenstrukturen entgegen des Richtungssinns der Leitbahnführung abgeknickt und in diesem Bereich siphonartig, ins Innere der Schleifenstruktur gerichtet gekrümmt ausgebildet sind, wobei die Leitbahnen in den jeweiligen siphonartigen Senken sich in einem Punkt senkrecht kreuzen und alle genannten Schleifenstrukturen in nur einer gemeinsamen Ebene liegend angeordnet sind, wobei alle Domänen führenden Schleifenabschnitte, inklusive der Kreuzungsbereiche, im Wesentlichen die gleiche Breite aufweisen. Da bei dieser Ausbildung des vorgesehenen Kreuzungsbereichs, der in einer Ebene mit allen anderen Leitbahnstrukturen in einem einheitlichen Strukturierungsprozess geschaffen werden, entfallen alle Herstellungsprobleme vergleichbarer Sensoren nach dem bekannten Stand der Technik, wie vorstehend beschrieben. Zugleich, da in der vorgeschlagenen neuen Topologie keine spitzen Winkel auftreten, die zu einer unerwünschten und unvermeidlichen Leitbahnverbreiterung führen, wird das nutzbare magnetische Fenster erheblich vergrößert. Dies hat zugleich eine spürbare Reduzierung der Anforderungen an das äußere, die Domänen treibende Magnetfeld zur Folge.

Die Aufgabe wird durch die kennzeichnenden Merkmale des Anspruchs 1 gelöst. Vorteilhafte Ausgestaltungen sind Gegenstand der nachgeordneten Ansprüche.

Die vorliegender Erfindung zugrunde liegenden Messaufgaben und damit die Anwendung des vorgeschlagenen magnetischen Sensors kommen, im Falle der Bestimmung von Umdrehungen, in der Technik in zwei Grundkonfigurationen vor: Entweder ist die Anzahl der Umdrehungen einer Welle zu bestimmen, die von der Seite zugänglich ist (dezentrale Anordnung oder Hohlwellensensoranordnung) oder der Sensor kann gegenüber einem Ende der Welle platziert werden (zentrale Anordnung). Zum anderen ist der vorgeschlagene magnetische Sensor auch zur absoluten Bestimmung von linearen Verschiebungen oder Teilumdrehungen mit extremer Genauigkeit einsetzbar.

Ein weiterer wesentlicher Vorteil der erfindungsgemäßen Lösung, insbesondere aus Sicht der Herstellungstechnologie, besteht darin, dass alle Domänen führenden Schleifenstrukturen einschließlich an sich kritischer Kreuzungsbereiche (vergleichen mit dem bekannten Stand der Technik) ausschließlich in einer einheitlichen Ebene ausbildbar sind.

Zur näheren Erläuterung des Vorstehenden und im Weiteren der Erfindung sollen nachstehende Ausführungsbeispiele und Figuren dienen. Es zeigen:

Fig. 1a      das Grundprinzip einer dezentralen Sensoranordnung (Hohlwellensensors);

Fig. 1b      das Grundprinzip einer zentralen Sensoranordnung;

Fig. 1c      beispielhaft im oberen Teil der Figur einen linearen magnetischen Maßstab und im unteren Teil ein Polrad gegenüber denen der erfindungsgemäße Sensors jeweils anordenbar ist;

Fig. 2      einen beispielhaften Schichtstapel, der für die Ausnutzung des GMR- bzw. den TMR-Effekts einsetzbar ist;

Fig. 3      eine erste beispielhafte erfindungsgemäße Ausführung eines Sensors mit einer hier dargestellten Schleifenausbildung mit zwei Spiralen in Draufsicht;

Fig. 3a      eine vergrößerte Darstellung eines erfindungsgemäß geschaffenen Kreuzungsbereichs der die zwei Schleifen verbindet nach Fig. 3;

Fig. 4      eine grundsätzliche beispielhafte Anordnung eines Sensors mit fünf Schleifen, kombiniert mit zwei ineinander gepackter 2-er und 3-er Schleifen und

Fig. 5      eine mögliche elektrische Kontaktierung anhand einer 5-er Schleifenstruktur.

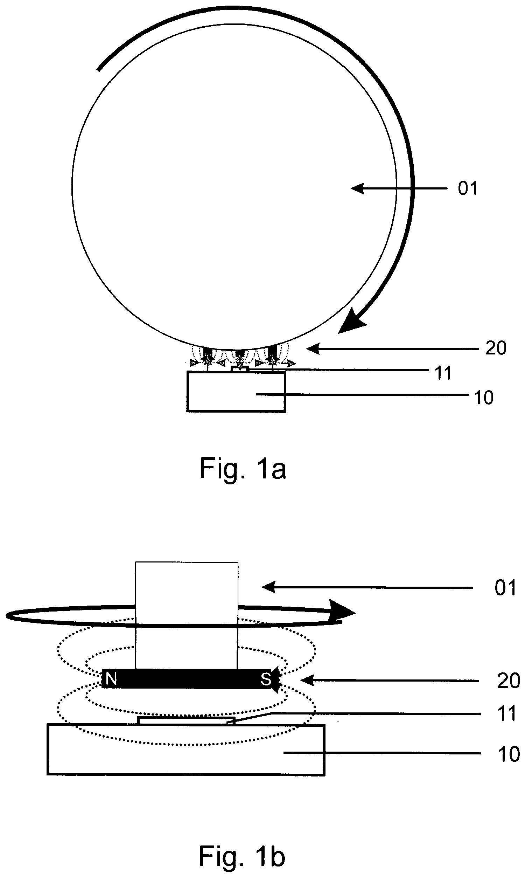

Die Figuren 1a und 1b zeigen zwei grundsätzliche Anordnungen, in denen der weiter unten detaillierter beschriebene erfindungsgemäße Sensor Anwendung finden kann. Dabei zeigt Fig. 1a einen Querschnitt durch ein Gesamtsystem mit dezentraler Anordnung (Hohlwellensensoranordnung), bestehend aus einer Welle 01 mit einem am Umfang angebrachten Magnetsystem 20, aus einem Si-Substrat 10 (vorteilhaft gleich eine Auswerteelektronik beinhaltend), auf dem sich ein erfindungsgemäßer Umdrehungszähler 11 befindet. Am Ort des Umdrehungszählers 11 wirkt von außen ein Magnetfeld, hier in Form einer Permanentmagnetkombination 20, die beim Vorbeibewegen eine Rotation der Richtung des Magnetfeldes um 360° am Ort des Umdrehungszählers 11 erzeugt. Da nach dem bekannten Stand der Technik Umdrehungszähler grundsätzlich in Verbindung mit einem deshalb hier nicht näher dargestellten Winkelsensor betrieben werden, kennt man aus dem Signal des Winkelsensors den Ort des sich drehenden Magnetfeldes.

In einer vorstehend erwähnten zweiten prinzipiellen Anwendungsmöglichkeit ist ein Permanentmagnet 20 an der Stirnfläche einer Welle 01 befestigt. Eine solche Ausführung zeigt Fig. 1b im Querschnitt durch ein Gesamtsystem mit zentraler Anordnung, bestehend aus einem Si-Substrat, vorteilhaft mit Auswerteelektronik 10, auf dem sich der erfindungsgemäße Umdrehungszähler 11 befindet. Am Ort des Sensors 11 wirkt von außen ein Magnetfeld eines sich am Ende der Welle 01 befindlichen Permanentmagneten 20, der so ausgeführt ist, dass der gesamte Umdrehungszähler von genanntem Magnetfeld erfasst wird, wie die beispielhaften Feldlinien andeuten sollen. Bei Drehung der Welle 01 um 360° erlebt der Umdrehungszähler 11 ebenfalls ein sich um 360° drehendes Magnetfeld. Auch in dieser Ausführungsform gilt, dass es Winkelbereiche gibt, bei denen die eingeschriebene Domänenkonfiguration gerade einer Änderung unterworfen wird und die dann ungültige Aussagen bezüglich der Anzahl von Umdrehungen liefern würden. Wenn dieser Bereich aber kleiner als 90° pro Halbumdrehung ist, dann kann bei Kenntnis des Winkels, bestimmbar z.B. mittels eines Winkelsensors, der gemeinsam mit dem Umdrehungszähler zum Einsatz kommt, oder durch die Verwendung eines Quadrantenzählers, also eines Winkelsensors, der bestimmen kann, in welchem Quadranten sich die Richtung des rotierenden Permanentmagneten befindet, eine eindeutige Bestimmung der Anzahl der Umdrehungen erreicht werden. Dies ist im Detail erläutert in IEEE Trans. Magn. Vol 45, Heft 10, S. 3792 - 3795. Da diese zusätzlichen Maßnahmen aber zum bekannten Stand der Technik gehören, bedürfen sie im Rahmen vorliegender Erfindung keiner weiteren erforderlichen Erläuterungen.

Die Domänenwände selbst bewegen sich im erfindungsgemäßen Sensor in einer, bspw. durch einen Strukturierungsprozess erzeugten Anordnung von mehreren weiter unten im Detail beschriebenen Schleifen, in denen durch einen zum Stand der Technik gehörenden Initialisierungsprozess jeweils eine definierte Anzahl von Domänenwänden eingeschrieben ist. Die Konfiguration dieser unterschiedlichen Schleifen ist so gestaltet, respektive ausgewählt, dass eine beliebig vorgebare Anzahl von äußeren Umdrehungen immer deren eineindeutige Zählung zulässt.

Die konkret vorliegenden Domänenkonfigurationen können mit Hilfe einer Anzahl von elektrischen Kontakten auf den Schleifen, aufgrund von magnetoresistiven Effekten, z.B. dem GMR-Effekt (Giant magneto resistance) oder dem TMR-Effekt (Tunneling magneto resistance), bestimmt werden und dadurch die Anzahl der Umdrehungen eines Magnetfeldes, das die Domänenwände in den geschlossenen Schleifen bewegt, ermittelt werden. Diese Bestimmung der Domänenkonfiguration nutzt den bekannten Effekt aus, dass der Widerstand in einem GMR- oder TMR-Stack von der relativen Richtung der Magnetisierung der Schicht abhängt, in der sich die Domänen bewegen, im Vergleich zu einer durch eine hartmagnetische Schicht definierten Referenzrichtung.

Der Widerstand ist niedrig, wenn die Richtung der Magnetisierung in der Referenz- und der Sensorschicht gleich ist und er steigt um (6 - 10)% (im Falle des GMR-Effektes) bzw. um (100 - 500)% im Falle des TMR-Effektes, wenn die Richtung der beiden Magnetisierungen antiparallel ist.

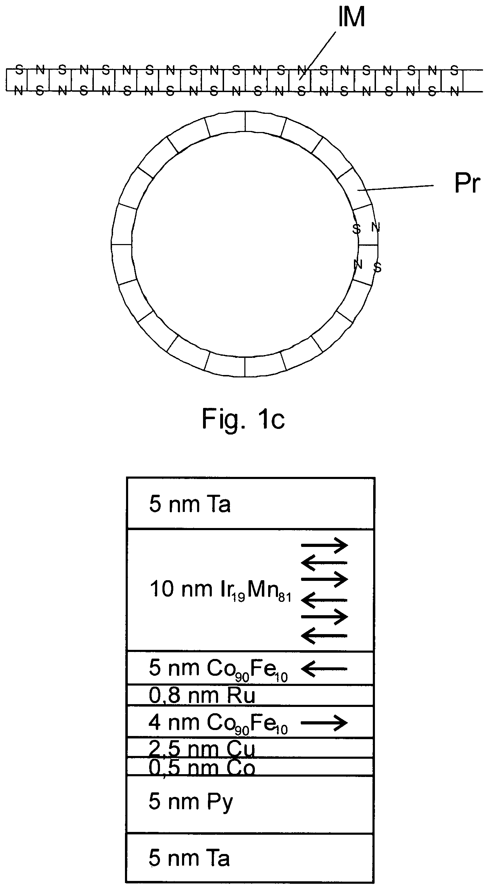

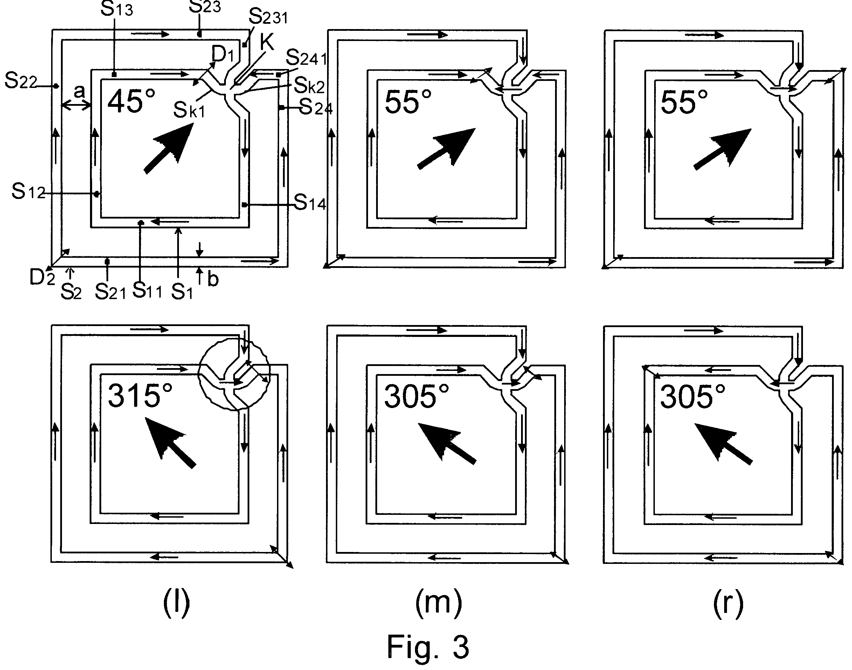

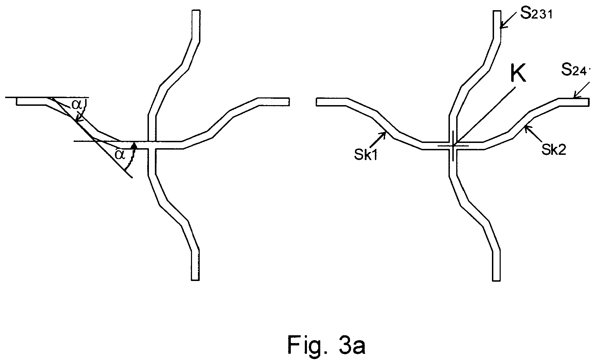

Figur 1c zeigt die Einsatzmöglichkeit eines erfindungsgemäßen Sensors in Verbindung mit einem linearen magnetischen Maßstab IM (siehe oberen Teil der Fig. 1c) in prinzipieller Darstellung. Auch hierbei erfahren die in die zu Fig. 3 näher dargestellten Sensorstruktur eingeschriebenen Domänen eine Bewegung durch diese Struktur, wenn sich der Sensor parallel zum Maßstab bewegt. Hat der Maßstab eine Pollänge von z.B. 1 mm erfährt der Sensor beim Bewegen um 1 mm eine komplette Rotation des Magnetfeldes um 360°. Auf diese Weise gelingt eine absolute Längenmessung. Zählt der Sensor bspw. bis 4096 Umdrehungen können Längen bis rund 4000 mm vermessen werden. Die Auflösung des Längenmeßsystems wird durch die Auflösung des dem Umdrehungszähler zugeordneten, hier ebenfalls nicht dargestellten Winkelmessers bestimmt. Beträgt diese z.B. 0,5° kann die Pollänge von 1 mm mit einer Genauigkeit von 0,5°/360° · 1mm ~ 1,4 $\mu$m vermessen werden. Die untere Abbildung in Fig. 1c zeigt beispielhaft ein Polrad Pr, das in einer Anordnung nach Fig. 1a eingesetzt werden kann, welches ebenfalls aus alternierend angeordneten und abwechselnd ausgerichteten Magnetsegmenten (analog zum linearen Maßstab) aufgebaut ist, was in dieser Abbildung nur zweimal angedeutet ist.

Die Figur 2 zeigt beispielhaft einen Schichtstapel, der für die Ausnutzung des GMR- bzw. den TMR-Effekts einzusetzen ist. Dabei ist in Fig. 2 ein solches, an sich bekanntes Schichtpaket im Querschnitt dargestellt. Für GMR-Schichtsysteme fließt der Strom in Richtung der eingezeichneten Magnetisierungspfeile (in der Schichtebene), der elektrische Widerstand wird durch elektrische Kontakte (hier nicht dargestellt), die in großer Entfernung (typischerweise bis 200 $\mu$m) voneinander entfernt aufgebracht sind, bestimmt.

Im Falle des Einsatzes eines TMR-Stapels bei vorliegender Erfindung ist die in Fig. 2 gezeigte 2,5 nm dicke Kupferschicht durch eine 1 - 2 nm dicke $Al_2O_3$ oder MgO-Schicht ersetzt. Der Strom fließt dann senkrecht durch den Schichtstapel von unten nach oben oder umgekehrt. Der TMR-Stapel nimmt im Allgemeinen eine Fläche von einigen bis einigen 10 bis 100 $\mu$m$^2$ ein. Weitere Ausführungen zu speziellen

Ausbildungsmöglichkeiten von GMR- oder TMR-Schichtstapeln an dieser Stelle erübrigen sich, weil diese an sich zum bekannten Stand der Technik gehören. Deshalb im Weiteren nur nachstehende Erläuterung:

Als eigentliche Sensorschicht, in der sich die magnetischen Domänen bewegen agiert eine $Ni_{81}Fe_{19}$ (Permalloy=Py)-Schicht, wobei die 0,5 nm dicke Co-Schicht nur dazu dient, den GMR- oder TMR-Effekt zu vergrößern. Als hartmagnetische Schicht dient eine Kombination aus einem sogenannten künstlichen Antiferromagneten (CoFe/0,8 nm Ru/CoFe in Kombination mit einem Antiferromagneten (in Fig. 2: IrMn, sonst auch NiMn oder PtMn). Die 0,8 nm dicke Ru-Schicht sorgt dafür, dass die magnetischen Momente der beiden CoFe-Schichten antiparallel ausgerichtet sind und sich idealerweise aufheben. Das IrMn in Kombination mit einer Co-Fe-Schicht erzeugt eine sogenannte unidirektionale Anisotropie. Damit ist die magnetische Vorzugsrichtung definiert. Sie kann im gesamten Wafer und damit auch in den erfindungsgemäß gebildeten Schleifen homogen sein.

Für die sichere Bewegung der Domänen in der Sensorschicht ist ein von der Geometrie (Höhe und Breite der Sensorschicht) und Magnetisierung des Materials der magnetisch weichen Schicht, die in der weiter unten beschriebenen erfindungsgemäße Schleifenform strukturiert ist, abhängiges Mindestfeld $H_{min}$ nötig. Zugleich erfordert das vorgeschlagene Prinzip, dass sich die Anzahl der Domänen innerhalb der Schleife während der Nutzung des Umdrehungszählers nicht ändert. Das bedeutet, dass das auf den Umdrehungszähler einwirkende Magnetfeld immer kleiner sein muss als ein Magnetfeld $H_{nuk}$, bei dem es zur Nukleation eines magnetischen Bereiches und damit zur Generierung zusätzlicher Domänenwände kommt, was allerdings problemlos durch die Wahl des auf den Umdrehungszähler einwirkenden Magnetfeldes des sich drehenden Permanentmagneten 20 (vgl. Fig. 1 a und 1 b, respektive linearer Maßstab IM oder Polrad Pr in Fig. 1 c) erfüllt werden kann. Wie oben bereits angedeutet, sind diese Anforderungen, bedingt durch die erfindungsgemäße neue Topologie, jedoch erheblich reduziert, da durch vorliegende Erfindung ein erheblich größeres magnetisches Fenster erzielbar ist. Alle vorstehend beschriebenen Maßgaben und Einsatzmöglichkeiten, die bereits zum bekannten Stand der Technik gehören, gelten in gleicher Weise für die im Rahmen dieser Erfindung vorgeschlagenen neuartigen Topologien.

Das Grundprinzip vorliegender Erfindung soll anhand von Figur 3 näher erläutert werden. Dabei zeigt Fig. 3 eine grundsätzliche Schleifenstruktur, im Beispiel bestehend aus zwei Spiralschleifen $S_1$ und $S_2$. Beide Spiralschleifen sind vom äußeren, sich in diesem Beispiel drehenden Magnetfeld (hierdurch einen mittig angeordneten fetten Pfeil dargestellt) in gleicher Weise erfasst. Zur Verdeutlichung des Topologieprinzips ist diese Figur nicht maßstäblich dargestellt, so dass manche Details hier stark überzeichnet sein müssen, um das Wesen vorliegender Erfindung ersichtlich zu machen. Um eine Vorstellung von der realen Konfiguration zu haben, sei mitgeteilt, dass im realisierten Beispiel die Breite b der die Domänen D (hier $D_1$ und $D_2$) führenden Leitbahnen 200 nm betragen, wohingegen der Abstand a der Schleifen zueinander in der Größenordnung von 5-10 $\mu$m festgelegt ist und die Gesamtfläche, die von der rhombischen Anordnung eingenommen wird in diesem Beispiel ca. 200 $\mu$m · 200 $\mu$m beträgt. Allein daraus wird ersichtlich, dass bei einer Anordnung von Sensoren, die mehr als zwei Schleifen beinhalten oder eine Kombination von mehreren Sensoren mit unterschiedlichen Schleifenanzahlen auf ausgesprochen kleinen Substratflächen möglich sind, so dass alle Sensoren vom makroskopisch deutlich größeren äußeren Magnetfeld in gleicher Weise problemlos erfassbar sind. In Fig. 3 deutet der innere dicke Pfeil die Richtung des hier in den oberen drei Abbildungen in Uhrzeigerrichtung angenommenen, drehenden äußeren Magnetfeldes an und soll in oberen linken Teil von Fig. 3 gerade bei 45° liegen. Die dünnen Pfeile in den Leitbahnen deuten die Richtung der lokalen Magnetisierungsrichtungen in den Leitbahnabschnitten an, wohingegen die hier eingeschriebenen zwei Domänen $D_1$ und $D_2$ durch einen Doppelpfeil dargestellt sind. Figur 3 zeigt dabei die Lagen der Domänen $D_1$ und $D_2$, die diese beispielhaft bei 45° angenommen haben sollen. Die Bewegung der Domänen $D_1$ und $D_2$ in den im Wesentlichen geraden rhombusartig angeordnet verlaufenden Teilabschnitten $S_{11}$, $S_{12}$, $S_{13}$, $S_{14}$ und $S_{21}$, $S_{22}$, $S_{23}$, $S_{231}$, $S_{24}$, $S_{241}$ ist unkritisch. Interessant ist der Bewegungsablauf der Domäne über die in einer Ebene auf dem Substrat vorgesehene erfindungsgemäße Kreuzung K. Würde die gesamte Kreuzung K ausschließlich rechtwinklig ausgeführt sein (hier nicht dargestellt), wäre es aus energetischer Sicht, bei weiterer Drehung des äußeren Magnetfelds, sehr viel wahrscheinlicher, dass sich die Domänenwand $D_1$ nach oben als, wie gewünscht, nach rechts in die Schleife $S_2$ bewegt. Damit wäre eine eineindeutige Zählung der Domänenumdrehung über die Schleifen nicht mehr gegeben. Um dies zu vermeiden, ist nach vorliegender Erfindung ein neuartig geschaffener Kreuzungsbereich K vorgesehen, der im Detail in Fig. 3a vergrößert dargestellt ist. Figur 3a stellt dabei nur den Ausschnitt des in Fig. 3 im unteren linken Bild mit einem Kreis umfassten Gebietes dar. Dort ist ersichtlich, wie der Kreuzungsbereich unmittelbar vor und nach dem Kreuzungsbereich, in und nach dem die Domäne $D_1$ von der ersten Schleife $S_1$ in die benachbarte Schleife $S_2$ nunmehr wechseln kann. Dazu ist den sich kreuzenden Schleifen $S_1$ und $S_2$ jeweils eine siphonartig, ins Innere der Schleifenstruktur gerichtet gekrümmt ausgebildete Struktur gegeben, innerhalb derer nur ein kurzer Leitbahnabschnitt der jeweiligen Senken senkrecht aufeinander steht. In den Figuren 3 und 3a sind die Senkenabschnitte der waagerecht verlaufenden Schleifenstruktur mit $S_{k1}$ und $S_{k2}$ bezeichnet, die analog ausgeführten Abschnitte der dazu senkrecht stehenden Senkenabschnitte sind nicht näher bezeichnet. Wichtig für die Funktionsfähigkeit der erfindungsgemäßen Lösung ist, dass beide Senkenkrümmungen (d.h. die waagerechte und die dazu senkrecht stehende Senke) in Richtung des Schleifeninneren weisen. Weiterhin wesentlich ist dabei, dass unmittelbar vor dem Kreuzungsbereich, in und nach dem die Domänen (D) von einer in die benachbarte Schleifenstruktur wechseln können, diese Abschnitte der Schleifenstrukturen entgegen des Richtungssinns der Leitbahnführung abgeknickt sind und den vorgeschlagenen siphonartigen Bereich bilden. Zur Erzielung der Änderung des Richtungssinns der Leitbahnführung dient der vorgesehene Abknickwinkel $\alpha$ vor Einlaufen der geraden Leitbahnabschnitte ($S_{13}$, $S_{241}$ und $S_{14}$, $S_{231}$) in die Senkenabschnitte ($S_{k1}$, $S_{k2}$), der jeweils betragsmäßig > 45° und kleiner 90° ausgeführt ist (vgl. Fig. 3a linke Abbildung). Die gleiche Maßgabe gilt für den dazu spiegelsymmetrischen Senkenabschnitt als auch für die zur ersten Senke senkrecht stehende zweite Senke, bei der aus Gründen der Übersichtlichkeit auf die Angabe weiterer Bezugszeichen verzichtet wurde. Dieser Abknickwinkel $\alpha$ kann prinzipiell zwischen >45° und < 90° gewählt sein, wird aus hier nicht weiter diskutierten Hysteresegründen im Rahmen der Erfindung jedoch bevorzugt zwischen >45° und <55° gewählt werden.

Die Wirkungsweise der erfindungsgemäßen siphonartigen Schleifenstrukturabschnitte wird aus Fig. 3 für Feldwinkel für 45° und 55° des äußeren Magnetfeldes (wiederum dargestellt durch dicke Pfeile in der Schleifenstruktur) im oberen Teil der Fig. 3 ersichtlich. Dort erkennt man, dass es erst bei einer Richtung des äußeren Magnetfeldes von > 45° zu einer Bewegung der Domänenwand (hier $D_1$) durch den Siphon hindurch kommt. Am Kreuzungspunkt K der beiden Siphons ist die, die Domäne $D_1$ treibende Feldrichtung jetzt so ausgerichtet, dass die Domäne $D_1$ gerade weiter läuft (treibender Feldwinkel ist 35°). Hingegen im senkrecht dazu verlaufenden Bereich ist das treibende Feld um 55° zur Kreuzungsrichtung gedreht. Deshalb ist es energetisch für die Domänenwand $D_1$ viel günstiger, waagerecht durch den Siphon durchzulaufen und dann die gewünschte Bewegung in die Schleife $S_2$ zu vollführen. Bei lateraler Ausdehnungen dieses Siphons, die typischerweise im Rahmen der Erfindung zwischen 0,5 $\mu$m und 10 $\mu$m gewählt ist, benötigt eine Domänenwand bei typischen Wandbewegungsgeschwindigkeiten zwischen 400 - 1000 m/s somit maximal 25ns (bei einer Ausdehnung des Siphons ~ 10 $\mu$m). In dieser Zeit darf sich die Richtung des äußeren Magnetfeldes nicht mehr als 10° geändert haben. Diese Maßgabe lässt damit Messungen von Rotationen bis zu 10°/25 ns = 1 U/$\mu$s, also $10^6$ U/s zu. Das ist für alle denkbaren Anwendungsfälle des Einsatzes erfindungsgemäßer Sensoren mehr als ausreichend.

Hat sich die Domänenwand $D_1$ im Beispiel bei 55° komplett durch die Kreuzung und den siphonartigen Bereich hindurch bewegt (wie in der oberen rechten Position von Fig. 3 gezeigt), kann es zu einer Zurückbewegung der Domäne $D_1$ erst kommen, wenn der Feldwinkel die 315° merklich unterschritten hat. Dann ist es aus energetischen Gründen wieder zwingend, dass die Domänenwand waagerecht durch den Siphon läuft.

Damit ist es mit der erfindungsgemäßen Lösung möglich, eine Kreuzung in die Schleifenstrukturen einzuschreiben, wobei durch die Anordnung der Kreuzung innerhalb einer siphonartigen Modifikationen der geraden, auf die Kreuzung zulaufenden Bereiche, immer sichergestellt wird, dass die Domäne die Kreuzung gerade überquert und nicht fälschlicherweise in einen Bereich der Kreuzung hineinwandert, der um 90° zur bisherigen Bewegungsrichtung gedreht ist. Es hat sich gezeigt, dass es ausreichend ist, wenn die sich im Punkt K senkrecht kreuzenden Leitbahnabschnitte der siphonartigen Struktur in einem Bereich, der ungefähr der Größenordnung der dreifachen Leitbahnbreite b entspricht, zueinander senkrecht ausgerichtet sind. Die unteren drei Abbildungen in Fig. 3 zeigen lediglich die Domänenbewegungen, wenn sich das äußere Magnetfeld entgegengesetzt der Uhrzeigerrichtung bewegt, um zu verdeutlichen, dass unabhängig von der Drehrichtung der vorgeschlagene Sensor in beiden Drehrichtungen des äußeren Magnetfelds in gleicher Weise wirkt.

Bereits mit dieser in Figur 3 dargestellten einfachsten Ausführung der Erfindung ist z.B. der Zustand bei einem Zweitakt-Motor eineindeutig bestimmbar, da in Kombination mit einem Winkelsensor ein Zähler, der bis 2 zählen kann, einen Winkel von 0°-720° absolut bestimmt. Dieser Sensor erreicht bei einem Winkel 720° wieder die 0°-Stellung und wiederholt den Prozess zyklisch.

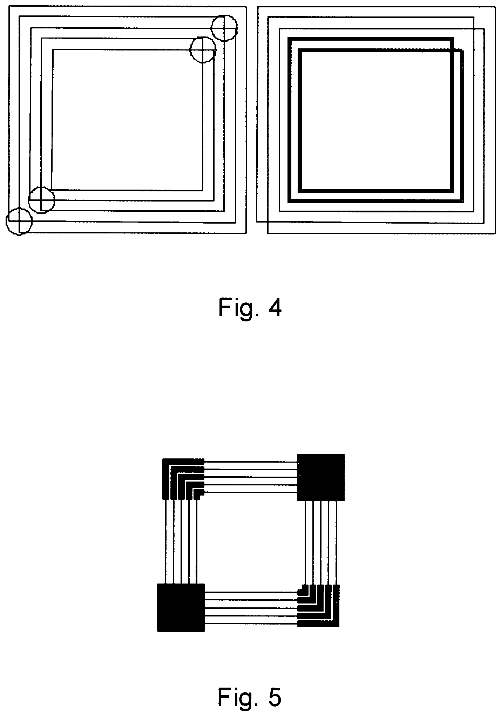

Im Rahmen der Erfindung ist jedoch die Anordnung von mehreren untereinander geschlossener Schleifenstrukturen $S_1$ bis Sn unter Beibehaltung des Prinzips hier vorgeschlagener Kreuzungen zwischen benachbarten Schleifen möglich. Wie dies aus der linken Darstellung in Figur 4 am Beispiel einer Schleifenstruktur mit fünf Schleifen schematisch ersichtlich ist, mit der fünf Umdrehungen eineindeutig detektierbar sind. Vorteilhaft, im Hinblick auf die erforderlichen elektrischen Kontaktierungen, ordnet man die, die hier nur symbolisch dargestellten Kreuzungsbereiche, diagonal über der hier dargestellten rhombusartigen Anordnung an, wie es durch die, die jeweiligen Kreuzungen umfassenden Kreise im linken Teil der Fig. 4 angedeutet ist. Der Einfachheit halber sind in Fig. 4 die Kreuzungen nur symbolisch dargestellt; sie folgen in ihrer tatsächlichen Ausbildung aber identisch den Maßgaben entsprechend der speziellen Beschreibung zu Fig. 3. Andere Anordnungen der Kreuzungsbereiche bei mehrteiligen in sich nur einmal schließenden Schleifenstrukturen liegen aber ausdrücklich im Rahmen der Erfindung, solange die Maßgabe der siphonartig ins Schleifeninnere gerichteten Krümmungen der Kreuzungsbereiche eingehalten ist.

In weiterer Ausgestaltung der Erfindung ist diese jedoch nicht auf eine einzige, mehrfache und in sich geschlossene Schleifenanordnung beschränkt. Das bei einer Erweiterung auf mehrere in sich jeweils geschlossene Schleifenanordnungen, die alle in unmittelbarer Nähe auf dem gleichen Substrat in einer Fläche anzuordnen sind, grundsätzlich einzuhaltende Prinzip ist ebenfalls in Fig. 4 angedeutet. Bei der anzustrebenden vorteilhaften Besetzung jeder in sich geschlossenen Schleifenanordnung mit jeweils zwei Domänen sind in Figur 4 links eine Schleifenanordnung mit fünf Schleifen und rechts daneben eine ineinander gepackte Schleifenanordnung, bestehend aus einer inneren 2-Schleifenanordnung und eine diese umgebenden 3-Schleifenanordnung beispielhaft gezeigt. Alle genannten Schleifenanordnungen sind, wie gesagt, mit jeweils zwei Domänen besetzt, so dass sich bei Umdrehung des äußeren, in Fig. 4 nicht dargestellten Magnetfeldes 2 · 3 · 5 = 30 Umdrehungen eineindeutig zählen lassen. Wesentlich im Rahmen der Erfindung, bei Anpassung an eine vorgebbare Anzahl von zu messenden Umdrehungen, respektive bei Erweiterung auf hohe Umdrehungszahlen, ist, wie bereits aus vorstehendem übersichtlichen Beispiel für 30 Umdrehungen erkennbar, dass die Anzahl der Schleifen pro in sich geschlossener Schleifenanordnung zu den anderen Schleifenanordnungen untereinander teilerfremd festgelegt ist, um eine eineindeutige Zählung zu gewährleisten.

Bei weiterer Umsetzung dieses Prinzips der Anordnung mehrerer teilerfremder Schleifenstrukturen wurden bei der Anmelderin experimentell bereits Schleifenanordnungen geschaffen, die die eineindeutige Zählung von 3465 Umdrehungen ermöglichen, wobei die dafür erforderlichen Schleifenanordnungen nur eine Fläche von ca. 500$\mu$m · 600$\mu$m beanspruchen. Diese kleinen von den Sensorstrukturen eingenommenen Flächen verdeutlichen, dass eine problemlose Erweiterung solcher Schleifenstrukturen zur Bestimmung von weit über 4000 Umdrehungen im Rahmen der Erfindung liegen, da die Abmessungen der äußeren Magnetfelderzeuger deutlich über diesen Dimensionen liegen.

Figur 5 zeigt nur beispielhaft, wie vorteilhaft die Art der Kontaktanbindung bei einer bspw. nach Fig. 4 (linke 5-er Schleife) geschaffenen Schleifenanordnung erfolgen kann. Die vorgesehenen und hier nicht näher bezeichneten Kontakte sind in Fig. 5 fett ausgeführt. Auf die Vorteile einer solchen Kontaktierungsart und der Ausbildung von Wheatstone-Halbbrücken wurde bereits in DE 10 2008 063 226 A1 ausführlich eingegangen. Diese Erkenntnisse und Maßgaben können auch in vorliegender Erfindung vollständig übernommen werden und werden deshalb hier nicht weiter ausgeführt.

Wie eingangs bereits ausgeführt, ist der Einsatz des vorgeschlagenen Sensors nicht ausschließlich auf die Zählung von Umdrehungen gerichtet. Die sich durch Einsatz des vorgeschlagenen Sensors ergebenden zusätzlichen Vorteile sollen anhand nachstehender Ausführungen verdeutlicht werden:

Andere Anwendungen nutzen aus, dass sich oberhalb einer linearen oder rotierenden Anordnung von Permanentmagneten, bei denen benachbarte Permanentmagnete um 180° gegeneinander gedreht angeordnet sind, wie in Fig. 1c angedeutet, in einen konstanten Abstand von der Anordnung der Permanentmagnete sich ebenfalls ein vom Betrag konstantes Magnetfeld ausbildet, dessen Richtung eine Rotation vollführt. Verwendet man ein Polrad mit genau 2N Permanentmagneten in Kombination mit einem Winkelsensor, der einen Winkel mit einer Auflösung von $\Delta\varphi$ messen kann, so erreicht man beim Einsatz dieses Winkelsensors für die Messung der Richtung des Magnetfeldes oberhalb des Polrades eine Winkelauflösung von $\Delta\varphi/2N$, also eine über die Anzahl der Permanentmagnete festlegbare beträchtliche Auflösungsverbesserung. Zugleich kann mit Hilfe eines Umdrehungszählers die Absolutwinkelposition bestimmt werden, wenn er so aufgebaut ist, dass er nach 2N Umdrehungen seine Ausgangslage erreicht. Ein beliebiger Winkelwert errechnet sich also aus folgender Formel:

$$\Omega=(n\cdot360°+\varphi)/2N$$

mit n als der Anzahl der gezählten Umdrehungen des Magnetfeldes oberhalb des Polrades ($0\leq n<2N$) und $\varphi$ als Messwinkel des Winkelsensors. Damit ist das Signal in 2N periodisch und die Auflösung um den Faktor 1/2N verbessert.

Als Beispiele seien hier genannt:

Durch die Kombination einer 5-er und 4-er Schleifenanordnung nach vorliegender Erfindung kann ein Polrad mit 20 einzelnen Permanentmagneten die Auflösung eines magnetischen Winkelsensors z.B. von 0,2° auf 0,01° verbessern und damit die Auflösung von optischen Sensoren erreichen.

Ähnliche Lösungsansätze ergeben sich, wenn man von einem inkrementalen magnetischen Sensor zu einem Absolutsensor übergehen will. Inkrementale magnetische Sensoren oder Decoder werden verwendet, um Strecken im mm bis m-Bereich zu vermessen. Dazu werden magnetische Maßstäbe verwendet, bei denen eine typische sogenannte Pollänge von 2 mm Verwendung findet. Die Kombination eines magnetischen Winkelsensors, der die relative Position innerhalb der 2 mm Pollänge auf wenige $\mu$m genau bestimmen kann, mit einem Umdrehungszähler, der die Anzahl der Polpaare zählt, an denen der Winkelsensor vorbei fährt, erlaubt den Aufbau eines Absolutencoders mit allen Vorteilen, den dieser gegenüber einem inkremental arbeitenden Längensensor aufweist. Ein erfindungsgemäßer Sensor, der z.B. bis 500 zählt, kann dann in Kombination mit einem inkremental arbeitenden Magnetsensor eine Wegstrecke von 1 m Länge auf 1 $\mu$m Genauigkeit absolut vermessen und registriert jede Verschiebung auch in einem Zustand, in dem das Sensorsystem nicht mit einer elektrischen Leistung versorgt wird (Bewegung in einem stromlosen Fall, wie z.B. Kurzschlussfall).

Alle in der Beschreibung, den Ausführungsbeispielen und der nachfolgenden Zeichnungen erkennbaren Merkmale können sowohl einzeln, als auch in beliebiger Kombination miteinander erfindungswesentlich sein.

Bezugszeichenliste

01 - Welle
10 - Substrat mit Auswerteelektronik
11 - Umdrehungszähler
20 - Magnetsystem
$D_1$, $D_2$ - magnetische Domänen
IM - linearer Maßstab
K - Kreuzungspunkt
Pr - Polrad
$S_1$, $S_2$ - Schleifen des magnetischen Sensors
$S_{11}$, $S_{12}$, $S_{13}$, $S_{14}$ und $S_{21}$, $S_{22}$, $S_{23}$, $S_{24}$, $S_{231}$, $S_{241}$ - gerade Schleifenteilabschnitte
$S_{k1}$, $S_{k2}$ - siphonartige Senkenabschnitte
$\alpha$ - Abknickwinkel

**Patentansprüche**

1. Magnetischer Sensor zur Ermittlung von absoluten Umdrehungs- oder Verschiebungswerten zur eineindeutigen Bestimmung einer vorgebbaren Anzahl zu ermittelnder Umdrehungen, respektive Teilumdrehungen, oder Verschiebungen eines mit einem Magnetsystem verbundenen Elements (20, IM, Pr), welches ein durch Drehung und/oder örtliche Lage des Elements treibendes, richtungsabhängiges, äußeres magnetisches Feld erzeugt, wobei der Sensor eine mit einer vorbestimmbaren Anzahl magnetischer Domänen (D) besetzte weichmagnetische und mit GMR- oder TMR-Schichtpaketen versehene Schleifenstruktur zur Erfassung des äußeren magnetischen Feldes umfasst, wobei wenigstens zwei separate Schleifen ($S_1$, $S_2$) mit überwiegend geraden und zueinander rhombusartig angeordnet verlaufenden Teilabschnitten ($S_{11}$, $S_{12}$, $S_{13}$, $S_{14}$ und $S_{21}$, $S_{22}$, $S_{23}$, $S_{24}$) vorgesehen sind, **dadurch gekennzeichnet, dass** die zumindest zwei Schleifen über einen gemeinsamen Kreuzungspunkt (K) miteinander verbunden sind, wobei jeweils unmittelbar vor dem Kreuzungsbereich, in und nach dem die Domänen (D) von einer in die benachbarte Schleife wechseln können, diese Abschnitte der Schleifenstruktur entgegen des ansonsten vorliegenden Richtungssinns der Leitbahnführung abgeknickt und in diesem Bereich siphonartig, ins Innere der Schleifenstruktur gerichtet gekrümmt ausgebildet sind, wobei die Leitbahnen in den jeweiligen siphonartigen Senken ($S_{k1}$, $S_{k2}$) sich in dem Kreuzungspunkt (K) senkrecht kreuzen und alle genannten Bestandteile der Schleifenstrukturen in nur einer gemeinsamen Ebene liegend angeordnet sind.

2. Magnetischer Sensor nach Anspruch 1, **dadurch gekennzeichnet, dass** zur Erzielung der Änderung des Richtungssinns der Leitbahnführung Abknickwinkel ($\alpha$) vor Einlaufen der geraden Leitbahnabschnitte ($S_{13}$, $S_{241}$ und $S_{14}$, $S_{231}$) in die Senkenabschnitte ($S_{k1}$, $S_{k2}$) vorgesehen sind, die jeweils betragsmäßig > 45° und kleiner 90°, bevorzugt kleiner 55°, ausgeführt sind.

3. Magnetischer Sensor nach Anspruch 1, **dadurch gekennzeichnet, dass** der Bereich der Leitbahnen, in dem sich die jeweiligen siphonartigen Senken ($S_{k1}$, $S_{k2}$) senkrecht kreuzen in etwa so lang ausgeführt ist, dass er die Größenordnung der dreifachen Leitbahnbreite (b) einnimmt.

4. Magnetischer Sensor nach Anspruch 1, **dadurch gekennzeichnet, dass** die Ausdehnung der siphonartigen Senken ($S_{k1}$, $S_{k2}$) zwischen 0,5 $\mu$m bis 10 $\mu$m festgelegt ist.

5. Magnetischer Sensor nach Anspruch 1 und einem oder mehreren der Ansprüche 2 bis 4, **dadurch gekennzeichnet, dass** innerhalb einer in sich geschlossenen Schleifenstruktur mehr als zwei separate Schleifen vorgesehen sind, die untereinander zur jeweils benachbarten Schleife jeweils über siphonartig gekrümmt ausgeführte Schleifenabschnitte miteinander verbunden sind.

6. Magnetischer Sensor nach Anspruch 1 oder 5, **dadurch gekennzeichnet, dass** mehr als zwei Schleifenstrukturen vorgesehen sind, die untereinander jeweils über siphonartig gekrümmte Schleifenabschnitte miteinander verbunden sind, wobei eine unterschiedliche Anzahl solcher jeweils in sich geschlossener Schleifenstrukturen mit voneinander getrennten Leitbahnen zur Domänenführung eng benachbart in einer Ebene vorgesehen sind, die untereinander eine unterschiedlich vorgebbare Anzahl von Schleifen beinhalten.

7. Magnetischer Sensor nach Anspruch 6, **dadurch gekennzeichnet, dass** die Anzahl der Windungen pro in sich geschlossener Schleifenstruktur zu der Anzahl der Windungen zu den anderen Schleifenstrukturen untereinander teilerfremd festgelegt ist.

8. Magnetischer Sensor nach Anspruch 1 und 5, **dadurch gekennzeichnet, dass** in einer rhombusartig ausgebildeten in sich geschlossenen Schleifenstruktur, die mehr als zwei sich kreuzende Schleifen beinhaltet, die Kreuzungen (K) auf einer Diagonale gegenüberliegend angeordnet sind.

## Claims

1. A magnetic sensor for ascertaining absolute revolution or displacement values for the bijective determination of a predefinable number of revolutions, or partial revolutions or displacements, to be ascertained of an element (20, IM, Pr) that is connected to a magnetic system and generates an anisotropic, external magnetic field, providing drive by way of the rotation and/or locational position of the element, the sensor comprising a soft magnetic loop structure, which is populated with a predeterminable number of magnetic domains (D) and provided with GMR or TMR layer assemblies, for the detection of the external magnetic field, wherein at least two separate loops ($S_1$, $S_2$) having predominantly straight subsections ($S_{11}$, $S_{12}$, $Si_{13}$, $Si_{14}$ and $S_{21}$, $S_{22}$, $S_{23}$, $S_{24}$), which extend in a rhombus-like arrangement with respect to each other, are provided, **characterized in that** the at least two loops are connected to each other via a shared intersecting point (K), wherein directly in front of each intersecting region, in which and after which the domains (D) can change from one loop to the neighbouring loop, these sections of the loop structure are bent against the sense of the direction of the normally present conductor guidance, and are curved in a siphon-like manner in this region so as to be directed into the interior of the loop structure, wherein the conductors in the respective siphon-like troughs ($S_{k1}$, $S_{k2}$) intersect perpendicularly at the intersecting point (K), and all described components of the loop structures are disposed so as to lie in only one shared plane.

2. The magnetic sensor according to claim 1, **characterized in that** bending angles ($\alpha$) are provided before the straight conductor sections ($S_{13}$, $S_{241}$ and $S_{14}$, $S_{231}$) approach the trough sections ($S_{k1}$, $S_{k2}$) so as to achieve the change in the sense of the direction of the conductor guidance, the bending angles in each case being designed to be, in absolute terms, > 45° and smaller than 90°, and preferably smaller than 55°.

3. The magnetic sensor according to claim 1, **characterized in that** the region of the conductors in which the respective siphon-like troughs ($S_{k1}$, $S_{k2}$) intersect perpendicularly is designed to be approximately long enough that it takes on the order of magnitude of triple the conductor width (b).

4. The magnetic sensor according to claim 1, **characterized in that** the dimension of the siphon-like troughs ($S_{k1}$, $S_{k2}$) is established between 0.5 $\mu$m and 10 $\mu$m.

5. The magnetic sensor according to claim 1 and one or more of claims 2 to 4, **characterized in that** more than two separate loops are provided within a closed loop structure, which are connected to each other and among each other to the respective neighbouring loop via loop sections that have a siphon-like curved design.

6. The magnetic sensor according to claim 1 or 5, **characterized in that** more than two loop structures are provided, which among each other are connected to each other via respective loop sections having a siphon-like curvature, wherein a different number of such respective closed loop structures having mutually separated conductors for domain guidance are provided in closely neighbouring positions in one plane, which among each other contain a variably predefinable number of loops.

7. The magnetic sensor according to claim 6, **characterized in that** the number of windings per closed loop structure is established in relation to the number of windings of the other loop structures in a coprime manner.

8. The magnetic sensor according to claims 1 and 5, **characterized in that** the intersections (K) are disposed opposite each other on a diagonal in a rhombus-like closed loop structure that contains more than two intersecting loops.

**Revendications**

1. Capteur magnétique permettant à saisir clairement en valeurs absolues les révolutions comptées ou les décalages, destiné à déterminer le nombre prédéfinissable de révolutions entières ou partielles ou de décalages d'un élément (20, IM, Pr) relié à un système magnétique, produisant par rotation et/ou en fonction de la position locale de l'élément un champ magnétique extérieur en fonction de la direction, le capteur comprenant une structure en boucle de paquets de couches métalliques magnétiques douces GMR ou TMR et étant dotée de domaines prédéfinis, pour assurer l'exploration du champ magnétique extérieur, avec au moins deux boucles distinctes ($S_1$,$S_2$) aux tronçons surtout droits et formant des losanges disposées face à face ($S_{11}$, $S_{12}$, $S_{13}$, $S_{14}$ et $S_{21}$, $S_{22}$, $S_{23}$, $S_{24}$) est **caractérisé en ce qu'**au moins les deux boucles distinctes reliées l'une à l'autre au point de croisement (K) se trouvant dans le secteur situé directement devant le point de croisement dans et après les domaines (D) de sorte qu'il soit possible de passer d'une boucle à la boucle voisine., contrairement à la situation telle qu'elle se présente pour les tronçons aux sens de pistes conductrices habituelles, les sections de la structure à boucle concernées prennent même une forme de siphon et sont coudées aux endroits orientés vers l'intérieur de la structure en boucle, les pistes conductrices se croisant dans les affaissement en forme de siphon ($S_{k1}$, $S_{k2}$) au point de croisement (K), tous les composants mentionnés en haut étant ainsi situés sur un plan commun.

2. Capteur magnétique suivant la revendication 1 est **caractérisé en ce que** pour obtenir un changement du sens de direction de la piste conductrice sont prévus aux endroits de l'arrivée des pistes conductrices droites ($S_{13}$, $S_{241}$ et $S_{14}$, $S_{231}$) dans les affaissements ($S_{k1}$, $S_{k2}$) des angles coudés ($\alpha$) dont les valeurs sont supérieures à 45° et inférieures à 90° et de préférence inférieures à 55°.

3. Capteur magnétique suivant la revendication est **caractérisé en ce que** la zone aux pistes conductrices où les affaissements à caractère de siphon ($S_{k1}$, $S_{k2}$) se croisent de manière perpendiculaire, doit avoir une longueur permettant d'atteindre pour la largeur la triple valeur des pistes conductrices (b).

4. Capteur magnétique suivant la revendication 1 est **caractérisé en ce que** l'extension des affaissements à caractère de siphon ($S_{k1}$, $S_{k2}$) se situe entre 0,5 $\mu$m à 10 $\mu$m.

5. Capteur magnétique suivant la revendication 1 ou une ou plusieurs revendications 2 à 4 est **caractérisé en ce qu'**une structure fermée en boucle comprend plus de deux boucles distinctes reliées entre elles et avec la boucle voisine par l'intermédiaire de sections coudées en forme de siphon.

6. Capteur magnétique suivant les revendications 1 ou 5 est **caractérisé en ce qu'**il est doté de deux structures en boucle qui sont reliées entre elles par l'intermédiaire des sections coudées en forme de siphon. Un nombre variable de structures en boucle fermées avec des pistes conductrices distinctes pour les domaines étroitement adjacents disposés dans un plan est prévu, le nombre prédéfini de boucles pouvant différer d'une structure à l'autre.

7. Capteur magnétique suivant la revendication, 6 est **caractérisé en ce que** le nombre de spires par structure en boucle fermée par rapport aux spires dans les autres structures en boucle sont premiers entre eux.

8. Capteur magnétique suivant les revendications 1 et 5 est **caractérisé en ce que** dans une structure en boucle fermée en forme de losanges comprenant plus de deux boucles qui se croisent, les points de croisement (K) sont disposés face à face sur une ligne diagonale.

Fig. 1a

Fig. 1b

IM

Pr

Fig. 1c

| 5 nm Ta |
|---|
| 10 nm $Ir_{19}Mn_{81}$ |
| 5 nm $Co_{90}Fe_{10}$ |
| 0,8 nm Ru |
| 4 nm $Co_{90}Fe_{10}$ |
| 2,5 nm Cu |
| 0,5 nm Co |
| 5 nm Py |
| 5 nm Ta |

Fig. 3

Fig. 3a

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1740909 B1
- WO 2005106395 A
- WO 2009027046 A1
- DE 102010022611 A1
- DE 102008063226 A1

**In der Beschreibung aufgeführte Nicht-Patentliteratur**

- *IEEE Trans. Magn.,* vol. 45 (10), 3792-3795